# EUROPEAN PATENT APPLICATION

(11) **EP 4 465 284 A1**
(43) Date of publication of application: **20.11.2024**
(21) Application number: 23209975.4
(22) Date of filing: 15.11.2023
(51) Int. Cl.: G09G 3/14

(54) **CHARLIEPLEXING IO-DRIVEN OLED SEGMENT**

(30) Priority: 16.05.2023 CN 202321166246 U
(71) Applicant: Foshan Run'An Photoelectric Techonology Co., Ltd, 528300 Foshan Guangdong (CN)
(72) Inventor: Lin, Yunzhong, Foshan, Guangdong, 528300 (CN); Zhu, Bin, Foshan, Guangdong, 528300 (CN); Li, Linhui, Foshan, Guangdong, 528300 (CN)
(74) Representative: Petraz, Gilberto Luigi

(57) **Abstract**

The present invention relates to a Charlieplexing IO-driven OLED segment, comprising a plurality of OLED segments and an MCU chip for supplying power to each of the OLED segments. The MCU chip has a plurality of I/O pins that can change the output electrodes at a preset time interval. Each I/O pin is electrically connected to the positive electrodes of the plurality of OLED segments and the negative electrodes of the plurality of OLED segments. The positive electrode and the negative electrode of each OLED segment are electrically connected to two of the I/O pins of the MCU chip, respectively. The MCU chip, by controlling the change of output electrodes of the I/O pins, enables the preset OLED segments to match each other with fast flashing to produce a visual effect of coherent illumination. The preset OLED segment does not need to remain lit, reducing overall energy consumption.

## Description

### CROSS-REFERENCE TO RELATED APPLICATION

This application claims the priority benefit of Chinese Patent Application No. 202321166246.7, filed on May 16, 2023, the entire content of which is hereby incorporated by reference herein and made a part of this specification.

### BACKGROUND

### Technical Field

The present invention relates to the technical field of OLEDs, specifically relates to a Charlieplexing IO-driven OLED segment.

### Description of Related Art

The various displays of the electrical system are indispensable auxiliary facilities for the control system of all power distribution devices and power consumption facilities. It is a necessary component for all power supply and distribution equipment, electrical control equipment, and power consumption equipment. It plays a role in the power supply display, operating state display of line or equipment, fault phenomenon display of power supply and consumption equipment, process location display of work facilities, and so on. The display is a signal display in all electrical facilities that reflects the operating state of the electrical system externally for the people concerned to perceive.

Existing displays are generally realized by using LED digital tubes and liquid crystal displays, and LED digital tubes and liquid crystal displays have a low contrast ratio in the process of use. Moreover, LED digital tubes and liquid crystal displays need to maintain an operating state of lit up in the process of displaying. Therefore, the energy consumption is relatively high.

Therefore, further improvements are needed.

### SUMMARY

For the purpose of overcoming the deficiencies of the prior art described above, the present invention proposes a technique for Charlieplexing IO-driven OLED segment, using a small number of I/O pins to control many OLED segments. Charlieplexing is the same as multiplexing, but it uses three-state logic (high, low, and high-resistance inputs) to significantly reduce the number of pins and improve multiplexing efficiency, reduce the number of I/O pins occupying the MCU chip in the circuit to achieve extreme cost reduction, aiming to solve, at least to a certain extent, the above technical problems in the prior art.

The present invention is implemented with a Charlieplexing IO-driven OLED segment, comprising a plurality of OLED segments and an MCU chip for supplying power to each of the OLED segments. The MCU chip has a plurality of I/O pins that can change the output electrodes at a preset time interval. Each I/O pin is electrically connected to the positive electrodes of the plurality of OLED segments and the negative electrodes of the plurality of OLED segments. The positive electrode and the negative electrode of each OLED segment are electrically connected to two of the I/O pins of the MCU chip, respectively.

The time interval for the I/O pin to change the output electrode is 5ms.

The OLED segment comprises diodes 1A, 1B, 1C, 1D, 1E, 1F, 1G, 2A, 2B, 2C, 2D, 2F, 2G, S1, S2, S3, S4, S5, and S6, and the MCU chip has I/O pins 1, 2, 3, 4 and 5.

The I/O pin 1 is electrically connected to the positive electrodes of diodes 1F, 1E, S1, and S4 and the negative electrodes of diodes 1A, S2, 2A, and 2B, respectively.

The I/O pin 2 is electrically connected to the positive electrodes of diodes 1A, 1G, 1D, and S5 and the negative electrodes of diodes 1F, 1B, 2F, and 2G, respectively.

The I/O pin 3 is electrically connected to the positive electrodes of diodes S2, 1B, 1C, and S6 and the negative electrodes of diodes 1E, 2E, 1G, and 2C, respectively.

The I/O pin 4 is electrically connected to the positive electrodes of diodes 2A, 2E, 2F, S3 and the negative electrodes of diodes S1, 1C, 2D, 1D, respectively.

The I/O pin 5 is electrically connected to the positive electrodes of diodes 2B, 2D, 2C, and 2G and the negative electrodes of diodes S4, S6, S3, and S5, respectively.

The diode S1 is in the shape of a number 1.

The diodes 1A, 1B, 1C, 1D, 1E, 1F are sequentially distributed in a clockwise direction, diode 1G is set in a center position between diodes 1A, 1B, 1C, 1D, 1E, 1F, diodes 1A, 1B, 1C, 1D, 1E, 1F, and 1G form a first numerical lamp group in the shape of a number 8, and the first numerical lamp group is set to the right side of diode S1.

The diodes 2A, 2B, 2C, 2D, 2E, 2F are sequentially distributed in a clockwise direction, diode 2G is set in a center position between diodes 2A, 2B, 2C, 2D, 2E, 2F, diodes 2A, 2B, 2C, 2D, 2E, 2F, and 2G form a second numerical lamp group in the shape of a number 8, and the second numerical lamp group is set to the right side of the first numerical lamp group.

The diode S2 is in the shape of a power symbol and a percent symbol and is set on the right side of the second numerical lamp group.

The diodes S3, S4, S5, and S6 form a liquid-level volume lamp group in the shape of a water droplet.

The beneficial effect of the present invention is that the MCU chip, by controlling the change of output electrodes of the I/O pins, enables the preset OLED segments to match each other with fast flashing to produce the visual effect of coherent illumination. The preset OLED segment does not need to remain lit up, reducing overall energy consumption. Moreover, the OLED segment has a better contrast ratio than LED digital tubes and liquid crystal displays. The OLED segment will not be broken down when the current is reversed.

Additional aspects and advantages of the present invention will become obvious in the description below or through the practice of the present invention.

### BRIEF DESCRIPTION OF THE DRAWINGS

FIG. 1 is a schematic diagram of a circuit according to an embodiment of the present invention.
FIG. 2 is a schematic diagram of the distribution of each OLED segment according to an embodiment of the present invention.
FIG. 3 is a schematic diagram of an I/O pin output of the MCU chip according to an embodiment of the present invention.
FIG. 4 is a schematic diagram I of Charlieplexing control logic for OLED segments.
FIG. 5 is a schematic diagram II of Charlieplexing control logic for OLED segments.

### DESCRIPTION OF THE EMBODIMENTS

The present invention is further described below in conjunction with the accompanying drawings and embodiments.

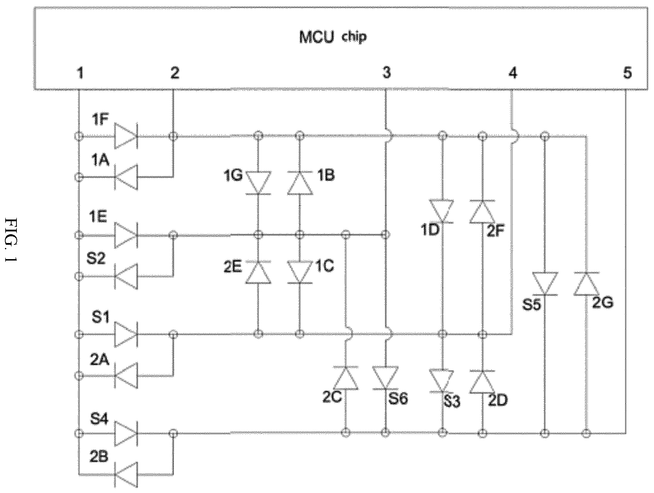

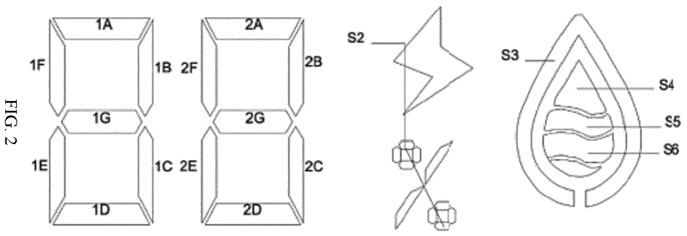

Referring to FIG. 1-FIG. 3, the proposed Charlieplexing IO-driven OLED segment comprises a plurality of OLED segments and an MCU chip for supplying power to each of the OLED segments. The MCU chip has a plurality of I/O pins that can change the output electrodes at a preset time interval. Each I/O pin is electrically connected to the positive electrodes of the plurality of OLED segments and the negative electrodes of the plurality of OLED segments. The positive electrode and the negative electrode of each OLED segment are electrically connected to two of the I/O pins of the MCU chip, respectively. The MCU chip, by controlling the change of output electrodes of the I/O pins, enables the preset OLED segments to match each other with fast flashing to produce the visual effect of coherent illumination. The preset OLED segment does not need to remain lit, reducing overall energy consumption. Moreover, the OLED segment has a better contrast ratio than LED digital tubes and liquid crystal displays. The OLED segment will not be broken down when the current is reversed.

In the case of controlling the same number of OLED segments, the proposed Charlieplexing IO-driven OLED segment can also significantly reduce the number of pins and improve the multiplexing efficiency, reduce the number of I/O pins occupying the MCU chip in the circuit to achieve extreme cost reduction.

Preferably, the MCU chip may be a single chip of the STC8 series or the STM32 series.

Further, the time interval for the I/O pin to change the output electrode is 5 ms.

Further, the OLED segment comprises diodes 1A, 1B, 1C, 1D, 1E, 1F, 1G, 2A, 2B, 2C, 2D, 2F, 2G, S1, S2, S3, S4, S5, and S6, and the MCU chip has I/O pins 1, 2, 3, 4 and 5.

The I/O pin 1 is electrically connected to the positive electrodes of diodes 1F, 1E, S1, and S4 and the negative electrodes of diodes 1A, S2, 2A, and 2B, respectively.

The I/O pin 2 is electrically connected to the positive electrodes of diodes 1A, 1G, 1D, and S5 and the negative electrodes of diodes 1F, 1B, 2F, and 2G, respectively.

The I/O pin 3 is electrically connected to the positive electrodes of diodes S2, 1B, 1C, and S6 and the negative electrodes of diodes 1E, 2E, 1G, and 2C, respectively.

The I/O pin 4 is electrically connected to the positive electrodes of diodes 2A, 2E, 2F, S3 and the negative electrodes of diodes S1, 1C, 2D, 1D, respectively.

The I/O pin 5 is electrically connected to the positive electrodes of diodes 2B, 2D, 2C, and 2G and the negative electrodes of diodes S4, S6, S3, and S5, respectively.

Further, the diode S1 is in the shape of a number 1.

The diodes 1A, 1B, 1C, 1D, 1E, 1F are sequentially distributed in a clockwise direction, diode 1G is set in a center position between diodes 1A, 1B, 1C, 1D, 1E, 1F, diodes 1A, 1B, 1C, 1D, 1E, 1F, and 1G form a first numerical lamp group in the shape of a number 8, and the first numerical lamp group is set to the right side of diode S1.

The diodes 2A, 2B, 2C, 2D, 2E, 2F are sequentially distributed in a clockwise direction, diode 2G is set in a center position between diodes 2A, 2B, 2C, 2D, 2E, 2F, diodes 2A, 2B, 2C, 2D, 2E, 2F, and 2G form a second numerical lamp group in the shape of a number 8, and the second numerical lamp group is set to the right side of the first numerical lamp group.

The diode S2 is in the shape of a power symbol and a percent symbol and is set on the right side of the second numerical lamp group.

The diodes S3, S4, S5, and S6 form a liquid-level indicator lamp group in the shape of a water droplet.

It should be noted that Charlieplexing (an algorithm named Charlieplexing) is a technique that uses a small number of I/O pins to control many OLED segments. Charlieplexing is the same as multiplexing, but it uses three-state logic (high and low inputs) to significantly reduce the number of pins and improve multiplexing efficiency. Charlieplexing allows control of N * (N - 1) OLED segments, wherein N is the number of the pin. For example, 20 OLED segments can be controlled using 5 Arduino pins 5 * (5-1) = 20. OLED SEGMENT is a diode, and in a diode, the current flows in only one direction. Therefore, in Charlieplexing, two OLED segments are connected in parallel with each other, but the polarities are opposite, and the number of pins can be reduced by Charlieplexing.

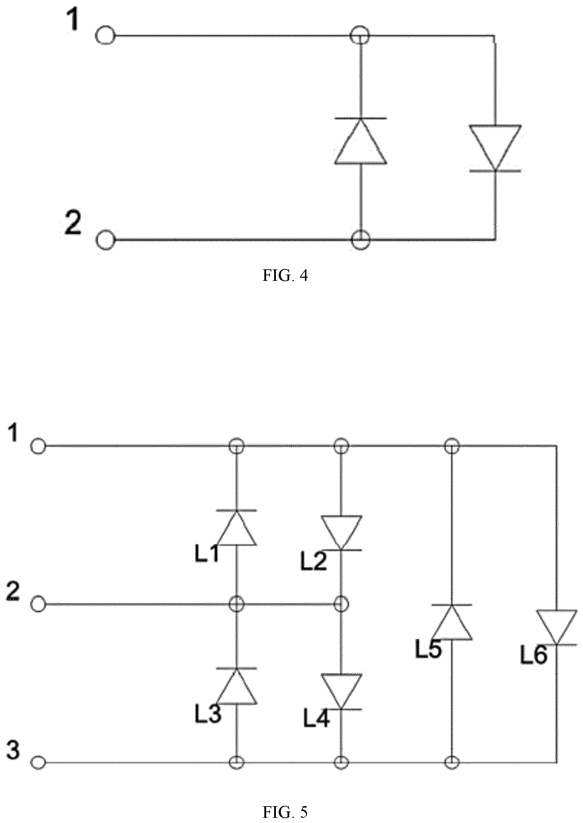

As shown in FIG. 4, the circuit uses two ports to control two OLED segments, and below is the operating principle. The two OLED segments are connected in inverse parallel. When port 1 is at a high level and port 2 is at a low level, the OLED segment on the right side is lit. In addition, when port 1 is at a low level and port 2 is at a high level, the OLED segment on the left side is lit.

As shown in FIG. 5, another port is added to control more OLED segments. The circuit is divided into 3 sub-circuits. Each sub-circuit indicates 2 ports. There are 2 OLED segments controlled by ports 1 and 2, another 2 OLED segments controlled by ports 1 and 3, and further another 2 OLED segments controlled by ports 2 and 3, for a total of 6 OLED segments. The microcontroller can individually control 6 OLED segments through only 3 ports.

When port 1 is at a high level and port 3 is at a low level, L6 will be lit. If port 2 is at a high level, L4 will also be lit. However, if port 2 is at a low level, L2 will be lit up at the same time. Therefore, when L4 and L2 do not need to be lit, port 2 only needs to be in a high-impedance state.

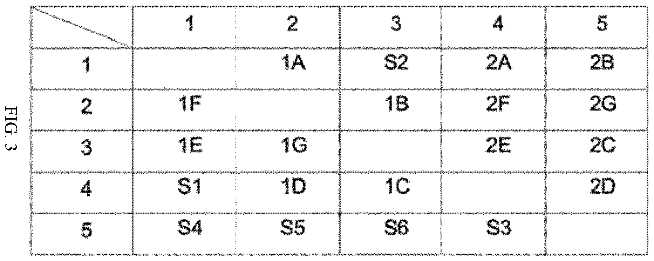

Take the first numerical lamp group that needs to display the number "0" as an example. As shown in FIG. 3, the MCU chip starts scanning I/O pin 1, and the output electrode of I/O pin 1 is positive. At this point, I/O pin 2 outputs a negative electrode, diode 1A is lit, and the other I/O pins are in a high-impedance state.

After 5ms from the start, the MCU chip starts scanning I/O pin 2, and the output electrode of I/O pin 2 is positive. At this point, the output electrode of I/O pins 1 and 3 is negative, diodes 1F and 1B are lit up, and the other I/O pins are in a high-impedance state.

After 10ms from the start, the MCU chip starts scanning I/O pin 3, and the output electrode of I/O pin 3 is positive. At this point, the output electrode of I/O pin 1 is negative, diode 1E is lit up, and the other I/O pins are in a high-impedance state.

After 15ms from the start, the MCU chip starts scanning I/O pin 4, and the output electrode of I/O pin 4 is positive. At this point, the output electrode of I/O pins 2 and 3 is negative, diodes 1D and 1C are lit up, and the other I/O pins are in a high-impedance state.

After 20ms from the start, the MCU chip starts scanning I/O pin 5, and the output electrode of I/O pin 5 is positive. At this time, the other I/O pins are in a high-impedance state.

Finally, go back to the beginning of the cycle. In this process, diodes 1A, 1F, 1B, 1E, 1D, and 1C are lit up quickly in turn. Since the interval for lit up is relatively large, it can be seen with the naked eye that the diodes 1A, 1B, 1C, 1D, 1E, and 1F are lit up at the same time, forming the number "0".

The above embodiments are only preferred embodiments of the present invention, and the present invention may have other embodiments. Those skilled in the art may also make equivalent variations or substitutions without departing from the spirit of the present invention, and these equivalent variations or substitutions are included within the scope outlined in the claims of the present application.

## Claims

1. A Charlieplexing IO-driven OLED segment, comprising:
a plurality of OLED segments; and
an MCU chip for supplying power to each of the plurality of OLED segments;
wherein the MCU chip has a plurality of I/O pins that can change the output electrodes at a preset time interval,
wherein each of the plurality I/O pins is electrically connected to positive electrodes of the plurality of OLED segments and negative electrodes of the plurality of OLED segments, and a positive electrode and a negative electrode of each of the plurality of OLED segments are electrically connected to two of the plurality of I/O pins of the MCU chip, respectively.

2. The Charlieplexing IO-driven OLED segment according to claim 1, wherein a time interval for a I/O pin to change a output electrode is 5ms.

3. The Charlieplexing IO-driven OLED segment according to claim 1, wherein the plurality of OLED segments comprise diodes 1A, 1B, 1C, 1D, 1E, 1F, 1G, 2A, 2B, 2C, 2D, 2F, 2G, S1, S2, S3, S4, S5, and S6, and the MCU chip has I/O pins 1, 2, 3, 4 and 5; wherein
the I/O pin 1 is electrically connected to positive electrodes of diodes 1F, 1E, S1, and S4 and negative electrodes of diodes 1A, S2, 2A, 2B, respectively;
the I/O pin 2 is electrically connected to positive electrodes of diodes 1A, 1G, 1D, and S5 and negative electrodes of diodes 1F, 1B, 2F, and 2G, respectively; the I/O pin 3 is electrically connected to positive electrodes of diodes S2, 1B,
1C, and S6 and negative electrodes of diodes 1E, 2E, 1G, and 2C, respectively;
the I/O pin 4 is electrically connected to positive electrodes of diodes 2A, 2E, 2F, S3 and negative electrodes of diodes S1, 1C, 2D, 1D, respectively; and
the I/O pin 5 is electrically connected to positive electrodes of diodes 2B, 2D, 2C, and 2G and negative electrodes of diodes S4, S6, S3, and S5, respectively.

4. The Charlieplexing IO-driven OLED segment according to claim 3, wherein the diode S1 is in a shape of a number 1;
wherein the diodes 1A, 1B, 1C, 1D, 1E, 1F are sequentially distributed in a clockwise direction, the diode 1G is set in a center position between the diodes 1A, 1B, 1C, 1D, 1E, 1F, wherein the diodes 1A, 1B, 1C, 1D, 1E, 1F, and 1G form a first numerical lamp group in a shape of a number 8, and the first numerical lamp group is set to a right side of the diode S 1;
wherein the diodes 2A, 2B, 2C, 2D, 2E, and 2F are sequentially distributed in a clockwise direction, and the diode 2G is set in a center position between the diodes 2A, 2B, 2C, 2D, 2E, 2F, wherein the diodes 2A, 2B, 2C, 2D, 2E, 2F, and 2G form a second numerical lamp group in the shape of the number 8, and the second numerical lamp group is set to a right side of the first numerical lamp group;
wherein the diode S2 is in a shape of a power symbol and in a shape of a percent symbol, and the diode S2 is set on a right side of the second numerical lamp group; and
wherein the diodes S3, S4, S5, and S6 form a liquid-level indicator lamp group in a shape of a water droplet.
